# EUROPEAN PATENT APPLICATION

(11) **EP 4 733 738 A1**
(43) Date of publication of application: **29.04.2026**
(21) Application number: 25209419.8
(22) Date of filing: 17.10.2025
(51) Int. Cl.: G01N 1/28, B23K 26/00, G01N 1/32, H01J 37/20

(54) **SAMPLE PROCESSING APPARATUS AND SAMPLE PROCESSING METHOD**

(30) Priority: 22.10.2024 JP 2024186082
(71) Applicant: Jeol Ltd., Akishima, Tokyo 196-8558 (JP)
(72) Inventor: INOUE, Noriyuki, Tokyo, 196-8558 (JP); MURAKAMI, Yuta, Tokyo, 196-8558 (JP)
(74) Representative: Boult Wade Tennant LLP

(57) **Abstract**

A sample processing apparatus (100) that irradiates a sample (S) disposed in a sample chamber (12) with a processing beam to process the sample (S), the sample processing apparatus (100) includes: a processing beam source (30) that irradiates the sample (S) with the processing beam; a sample holder (50) that holds the sample (S); a sample stage (40) on which the sample holder (50) is mounted; and a shield (60) disposed in the sample chamber (12), wherein the sample holder (50) and the shield (60) form a container (2) that accommodates the sample (S), and the container (2) is provided with a window portion (64) that guides the processing beam into the container (2).

## Description

### BACKGROUND OF THE INVENTION

### Field of the Invention

The present invention relates to a sample processing apparatus and a sample processing method.

### Description of Related Art

In analytical apparatuses such as scanning electron microscopes and transmission electron microscopes, samples to be observed or analyzed are processed into shapes suitable for observation or analysis using sample processing apparatuses. Examples of such sample processing apparatuses include cross-section polishers (TM) using ion beams, focused ion beam apparatuses using focused ion beams, and laser processing apparatuses using laser light.

In such sample processing apparatuses, cutting debris generated during processing may have an adverse effect. For example, JP 2013-214513 A discloses a processing apparatus in which a sample is processed using a laser beam within a vacuum chamber, the processing apparatus being provided with a protection screen between the sample and an objective lens to protect the objective lens from cutting debris generated during processing.

However, cutting debris generated during processing scatters in various directions from the laser beam irradiation position. For this reason, for example, in the apparatus disclosed in JP 2013-214513 A, cutting debris generated during processing may scatter within the vacuum chamber and adhere to optical systems other than the objective lens, detectors, inner surfaces of the vacuum chamber, and the like.

### SUMMARY OF THE INVENTION

According to a first aspect of the present disclosure, there is provided a sample processing apparatus that irradiates a sample disposed in a sample chamber with a processing beam to process the sample, the sample processing apparatus including:
a processing beam source that irradiates the sample with the processing beam;
a sample holder that holds the sample;
a sample stage on which the sample holder is mounted; and
a shield disposed in the sample chamber, wherein
the sample holder and the shield form a container that accommodates the sample, and
the container is provided with a window portion that guides the processing beam into the container.

According to a second aspect of the present disclosure, there is provided a sample processing method including:
mounting a sample holder holding a sample on a sample stage disposed in a sample chamber of a sample processing apparatus;
observing the sample using an observation beam and determining a processing region of the sample;
accommodating the sample in a container formed by a shield and the sample holder; and
guiding a processing beam into the container through a window portion provided in the container and processing the sample accommodated in the container using the processing beam.

### BRIEF DESCRIPTION OF THE DRAWINGS

FIG. 1 is a perspective view schematically illustrating a sample processing apparatus according to the present embodiment.
FIG. 2 is a plan view schematically illustrating a sample processing apparatus according to the present embodiment.
FIG. 3 is a perspective view schematically illustrating a sample holder and a shield.
FIG. 4 is a perspective view schematically illustrating a sample holder and a shield.
FIG. 5 is a perspective view schematically illustrating a sample holder and a shield.
FIG. 6 is a perspective view schematically illustrating a shield.
FIG. 7 is a perspective view schematically illustrating a shield.
FIG. 8 is a perspective view schematically illustrating a container.
FIG. 9 is a flowchart illustrating an example of a measurement method including a sample processing method using a sample processing apparatus.
FIG. 10 is a diagram for illustrating each step of a measurement method including a sample processing method using a sample processing apparatus.
FIG. 11 is a diagram for illustrating each step of a measurement method including a sample processing method using a sample processing apparatus.
FIG. 12 is a perspective view schematically illustrating a modified example of a sample holder and a shield.
FIG. 13 is a perspective view schematically illustrating a modified example of a shield.
FIG. 14 is a perspective view schematically illustrating a modified example of a shield.
FIG. 15 is a perspective view schematically illustrating a modified example of a shield.
FIG. 16 is a perspective view schematically illustrating a modified example of a shield.
FIG. 17 is a perspective view schematically illustrating a modified example of a sample holder and a shield.
FIG. 18 is a perspective view schematically illustrating a modified example of a sample holder and a shield.
FIG. 19 is a perspective view schematically illustrating a modified example of a container.
FIG. 20 is a cross-sectional view schematically illustrating a connecting portion between a sample holder and a shield.
FIG. 21 illustrates a modified example of a container.
FIG. 22 illustrates a modified example of a container.
FIG. 23 illustrates a modified example of a container.
FIG. 24 illustrates a modified example of a container.
FIG. 25 is a set of perspective views schematically illustrating a modified example of a sample holder and a shield.
FIG. 26 is a set of perspective views schematically illustrating a modified example of a sample holder and a shield.

### DESCRIPTION OF THE INVENTION

According to an embodiment of the present disclosure, there is provided a sample processing apparatus that irradiates a sample disposed in a sample chamber with a processing beam to process the sample, the sample processing apparatus including:
a processing beam source that irradiates the sample with the processing beam;
a sample holder that holds the sample;
a sample stage on which the sample holder is mounted; and
a shield disposed in the sample chamber, wherein
the sample holder and the shield form a container that accommodates the sample, and
the container is provided with a window portion that guides the processing beam into the container.

In such a sample processing apparatus, a sample may be processed within the container, thereby enabling a reduction in cutting debris that scatters within the sample chamber.

According to an embodiment of the present disclosure, there is provided a sample processing method including:
mounting a sample holder holding a sample on a sample stage disposed in a sample chamber of a sample processing apparatus;
observing the sample using an observation beam and determining a processing region of the sample;
accommodating the sample in a container formed by a shield and the sample holder; and
guiding a processing beam into the container through a window portion provided in the container and processing the sample accommodated in the container using the processing beam.

In such a sample processing method, a sample may be processed within the container, thereby enabling a reduction in cutting debris that scatters within the sample chamber.

Now, preferred embodiments of the present invention will be described in detail with reference to the drawings. The embodiments described below are not intended to unduly limit the contents of the present invention described in the claims. Further, all of the components described below are not necessarily essential requirements of the present invention.

### 1. Sample Processing Apparatus

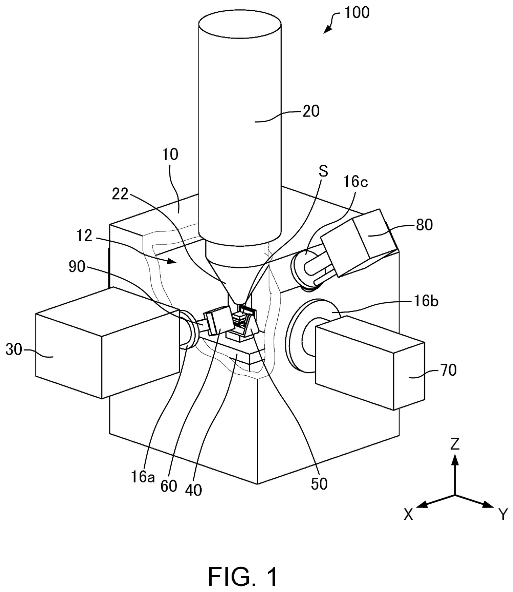

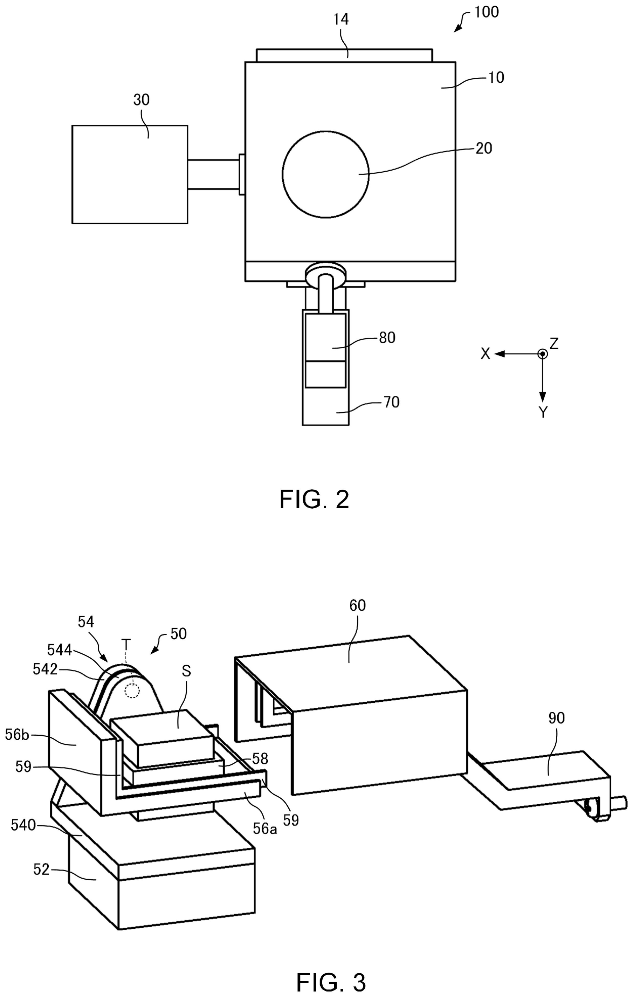

First, a sample processing apparatus according to an embodiment of the present invention will be described with reference to the drawings. FIG. 1 is a perspective view schematically illustrating a sample processing apparatus 100 according to the present embodiment. Note that in FIG. 1, a part of a housing 10 is omitted. FIG. 2 is a plan view schematically illustrating the sample processing apparatus 100 according to the present embodiment. In FIGS. 1 and 2, X, Y, and Z axes are illustrated as three axes orthogonal to each other.

As illustrated in FIGS. 1 and 2, the sample processing apparatus 100 includes the housing 10 having a sample chamber 12, a scanning electron microscope (SEM) column 20 serving as an observation beam source, a laser device 30 serving as a processing beam source, a sample stage 40, a sample holder 50, a shield 60, an electron backscatter diffraction detector (EBSD detector) 70, and an energy-dispersive X-ray spectrometer (EDS detector) 80.

The housing 10 has the sample chamber 12 in which a sample S is accommodated. The SEM column 20, the laser device 30, the EBSD detector 70, and the EDS detector 80 are attached to the housing 10. The SEM column 20 is attached to the surface of the housing 10 that faces in the +Z direction. A connection port (port) 16a is provided on the surface of the housing 10 that faces in +X direction, and a connection port 16b is provided on the surface of the housing 10 that faces in the +Y direction. The laser device 30 is attached to the connection port 16a. The EBSD detector 70 is attached to the connection port 16b. A connection port 16c is further provided on the housing 10, and the EDS detector 80 is attached to the connection port 16c.

The sample S, which is to be processed and observed, is accommodated in the sample chamber 12. The sample chamber 12 is evacuated by a vacuum evacuation device (not illustrated) and maintained in a vacuum (depressurized) state. The housing 10 is provided with a door 14. The sample S held by the sample holder 50 is loaded into the sample chamber 12 through the door 14.

The SEM column 20 irradiates the sample S with an electron beam. The electron beam is irradiated onto the sample S along the Z axis. The SEM column 20 includes an electron gun that emits an electron beam and an electron optical system that focuses the electron beam to form an electron probe and scans the sample S with the formed electron probe. The electron optical system includes an objective lens 22. The objective lens 22 is positioned closest to the sample S and focuses the electron probe on the surface of the sample S.

In the sample processing apparatus 100, the sample S is scanned with the electron probe, and electrons emitted from the sample S are detected by an electron detector (not illustrated), thereby enabling the acquisition of an SEM image.

The laser device 30 irradiates the sample S with processing laser light, thereby enabling the processing of the sample S. The laser device 30 may also process the sample S by scanning it with laser light. For example, in the processing of the cross section of the sample S, it is possible to process a larger area in a shorter time by using the laser light as the processing beam, compared to using a focused ion beam (FIB).

A sample stage 40 is disposed in the sample chamber 12. The sample holder 50 is placed on the sample stage 40. The sample stage 40 is capable of moving the sample holder 50 in both the horizontal and vertical directions. That is, the sample stage 40 is capable of moving the sample holder 50 along each of the X, Y, and Z axes. In addition, the sample stage 40 is capable of tilting the sample holder 50.

The sample holder 50 holds the sample S. The sample holder 50 is mounted on the sample stage 40. The sample holder 50 is mountable on and detachable from the sample stage 40.

The shield 60 is disposed in the sample chamber 12. The shield 60 is supported by a support member 90. The shield 60 is fixed to the housing 10 via the support member 90. As will be described later, the shield 60 is used to reduce cutting debris that scatters within the sample chamber 12.

The EBSD detector 70 acquires an electron diffraction pattern obtained using electron backscatter diffraction. For example, when an electron beam is incident on the surface of the sample S at an angle of approximately 70°, electrons are diffracted and emitted from the sample S as reflected electrons. The electron diffraction pattern thus generated is acquired by the EBSD detector 70. By scanning the sample S with the electron beam and acquiring the electron diffraction pattern, it is possible to obtain an EBSD mapping image. In the EBSD mapping image, the orientation of crystal grains, crystal grain boundaries, crystal phase differences, and the like are visualized.

The EDS detector 80 acquires an X-ray spectrum by discriminating, according to energy, the X-rays emitted from the sample S when the sample S is irradiated with the electron beam. From the X-ray spectrum, it is possible to obtain composition information on the sample S.

In the sample processing apparatus 100, SEM observation, EBSD measurement, and EDS measurement are performed at an observation position located below the objective lens 22 (the -Z direction). In a state in which the sample holder 50 holding the sample S is located at the observation position, the sample S is irradiated with the electron beam from the SEM column 20, and an SEM image is captured. Similarly, in a state in which the sample holder 50 holding the sample S is located at the observation position, the sample S is irradiated with the electron beam from the SEM column 20, and EBSD measurement and EDS measurement are performed. Note that FIG. 1 illustrates a state in which the sample holder 50 is located at the observation position.

Furthermore, in the sample processing apparatus 100, laser processing is performed at a processing position located in front of the connection port 16a to which the laser device 30 is connected (the -X direction). In a state in which the sample holder 50 holding the sample S is located at the processing position, the sample S is irradiated with the laser light from the laser device 30 and subjected to laser processing.

The laser processing of the sample S results in the generation of cutting debris. The cutting debris generated from the sample S scatters in various directions. In a state in which the sample holder 50 is located at the processing position, the sample S is accommodated in a container that is formed by the sample holder 50 and the shield 60. Therefore, the sample processing apparatus 100 enables a reduction in the cutting debris that scatters within the sample chamber 12.

As described above, the EBSD measurement is performed with the sample S tilted at 70°. Therefore, the sample S is subjected to laser processing while being tilted at 70°. Accordingly, as illustrated in FIG. 1, the shield 60 is tilted at an angle of 70° and fixed to the sample chamber 12 to fit the sample holder 50 tilted at an angle of 70°.

The processing position is located in the +X direction of the observation position, and the observation position and the processing position are aligned along the X axis. Therefore, the sample holder 50 can be moved between the observation position and the processing position only by moving the sample holder 50 along the X axis on the sample stage 40. Accordingly, the sample processing apparatus 100 enables a reduction in the displacement of the sample S that is caused by movement between the observation position and the processing position. Note that the positional relationship between the observation position and the processing position is not limited to this.

### 2. Sample Holder and Shield

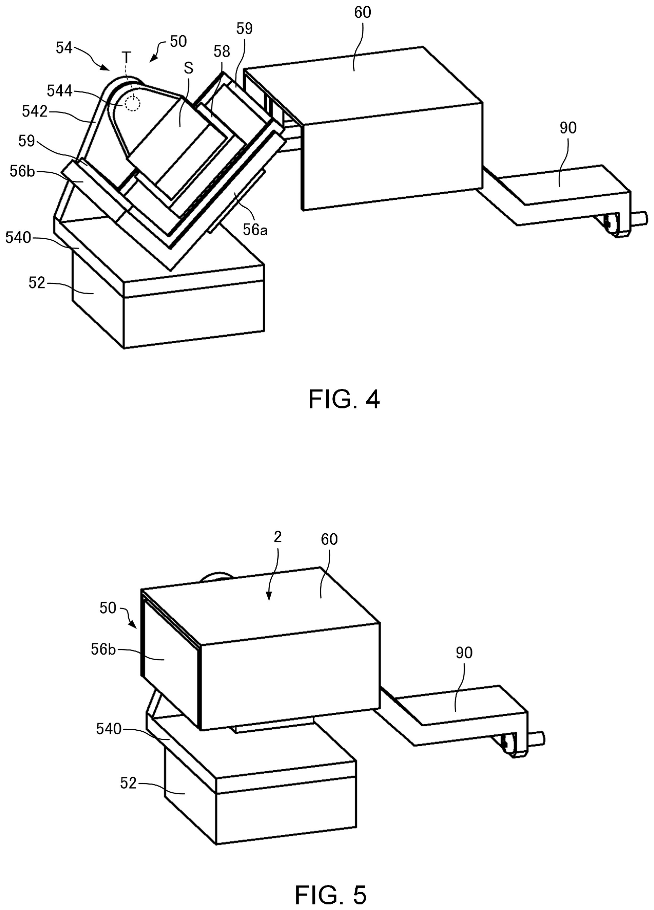

FIGS. 3 to 5 are perspective views schematically illustrating the sample holder 50 and the shield 60. FIG. 3 illustrates a state in which the sample holder 50 is located at the observation position. FIG. 4 illustrates a state in which a sample platform 58 is tilted. FIG. 5 illustrates a state in which the sample holder 50 is located at the processing position. Note that, as illustrated in FIG. 1, the shield 60 is tilted at an angle of 70° and fixed to the sample chamber 12. However, in FIGS. 3 to 5, the shield 60 is illustrated as not being tilted for the sake of convenience.

As illustrated in FIGS. 3 to 5, the sample holder 50 has a base 52, a tilting mechanism 54, a first member 56a, a second member 56b, the sample platform 58, and a protruding portion 59.

The base 52 is mounted on the sample stage 40. The tilting mechanism 54 is provided on the base 52.

The tilting mechanism 54 tilts the sample platform 58 at an arbitrary angle. As a result, the sample S placed on the sample platform 58 is capable of being tilted as illustrated in FIG. 4. The tilting mechanism 54 has a base portion 540, a projecting portion 542 that projects perpendicularly from the base portion 540, and a connecting portion 544 that is connected to the first member 56a.

The base portion 540 is fixed to the base 52. The projecting portion 542 and the connecting portion 544 are connected via a tilting shaft T. The tilting mechanism 54 has a driving unit that rotates the connecting portion 544 about the tilting shaft T. The driving unit rotates the connecting portion 544 using, for example, power from a motor or the like. By rotating the connecting portion 544 about the tilting shaft T via the driving unit, it is possible to integrally tilt the first member 56a, the second member 56b, and the sample platform 58 as illustrated in FIG. 4.

Note that the configuration of the tilting mechanism 54 is not particularly limited as long as it is capable of tilting the sample platform 58.

As illustrated in FIG. 5, the sample holder 50 and the shield 60 form, at the processing position, a container 2 that accommodates the sample S. The first member 56a and the second member 56b are members used to form the container 2. The first member 56a defines the bottom surface of the container 2. The second member 56b defines one of the four side surfaces of the container 2.

The sample platform 58 is disposed on the first member 56a. The sample S is placed on the sample platform 58. By tilting the sample platform 58 using the tilting mechanism 54, it is possible to tilt the sample S.

A protruding portion 59 is provided at the connecting portion between the sample holder 50 and the shield 60. The protruding portion 59 is provided on the first member 56a and the second member 56b of the sample holder 50. The protruding portion 59 is provided to surround the sample platform 58.

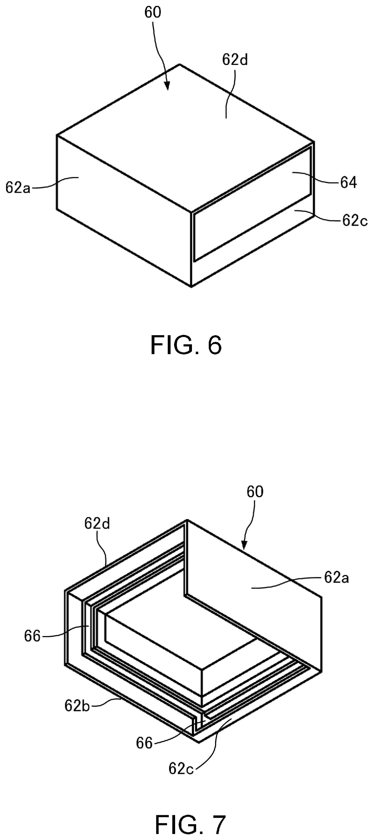

FIGS. 6 and 7 are perspective views schematically illustrating the shield 60.

The shield 60 has a third member 62a, a fourth member 62b, a fifth member 62c, a sixth member 62d, a window portion 64, and a recess portion 66. The third member 62a defines one of the four side surfaces of the container 2. The fourth member 62b defines one of the four side surfaces of the container 2. The fifth member 62c defines one of the four side surfaces of the container 2. The sixth member 62d defines an upper surface of the container 2.

The container 2 is formed by the first member 56a, the second member 56b, the third member 62a, the fourth member 62b, the fifth member 62c, and the sixth member 62d. The first member 56a, the second member 56b, the third member 62a, the fourth member 62b, the fifth member 62c, and the sixth member 62d form the six surfaces that surround the sample S. The sample S is accommodated in the space surrounded by the six surfaces (the inner surfaces of the container 2). The container 2 surrounds four sides of the sample S by the six surfaces.

The inner surfaces of the container 2 have minute irregularities formed thereon so that cutting debris adhering during laser processing does not easily detach. For example, irregularities with a size of approximately several hundred micrometers to one millimeter are formed on the inner surfaces of the container 2. For example, irregularities may be formed on the inner surfaces of the container 2 by forming a film of metal, ceramic, cermet, or the like on the inner surfaces of the container 2 through thermal spray processing. As a result, cutting debris adhering during laser processing is less likely to detach from the inner surfaces of the container 2. Furthermore, the members forming the inner surfaces of the container 2, that is, the first member 56a, the second member 56b, the third member 62a, the fourth member 62b, the fifth member 62c, and the sixth member 62d may be made of a material that reduces the likelihood of cutting debris adhering during laser processing detaching from the inner surfaces of the container 2.

The window portion 64 guides laser light into the container 2. The window portion 64 enables the laser light to pass through. The material of the window portion 64 is, for example, glass. The window portion 64 is provided on the fifth member 62c having a surface that faces the laser device 30. The window portion 64 is replaceable with respect to the container 2. The window portion 64 is attachable to and detachable from the fifth member 62c.

The recess portion 66 is provided at the connecting portion between the shield 60 and the sample holder 50. As illustrated in FIG. 7, the recess portion 66 is provided on the inner surfaces of the shield 60. When the sample holder 50 is located at the processing position, the protruding portion 59 is inserted into the recess portion 66.

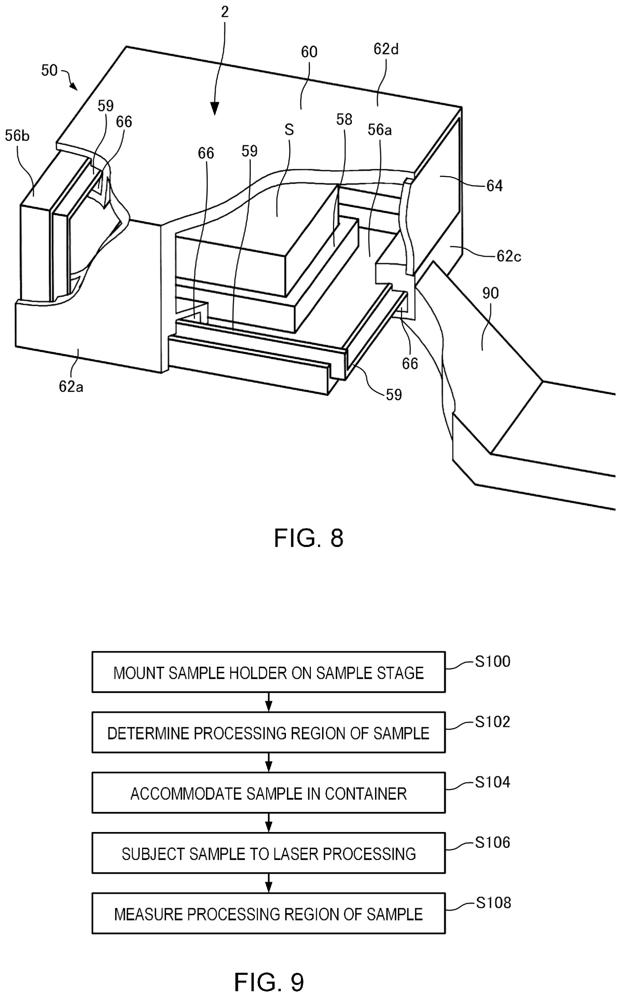

FIG. 8 is a perspective view schematically illustrating the container 2.

As illustrated in FIG. 8, when the container 2 is formed by the sample holder 50 and the shield 60, the protruding portion 59 is inserted into the recess portion 66. Therefore, the path connecting the inside and outside of the container 2 may be bent at the connecting portion between the sample holder 50 and the shield 60. Accordingly, for example, compared to a case in which the path connecting the inside and outside of the container 2 is linear, it is possible to reduce the likelihood of cutting debris escaping from the connecting portion between the sample holder 50 and the shield 60 to the outside of the container 2.

Note that in the example illustrated in FIGS. 3 to 8 described above, the sample holder 50 is provided with the protruding portion 59, and the shield 60 is provided with the recess portion 66. However, although not illustrated, the shield 60 may be provided with a protruding portion, and the sample holder 50 may be provided with a recess portion into which the protruding portion is inserted. Even in this case, the same functions and effects may be obtained.

### 3. Sample Processing Method

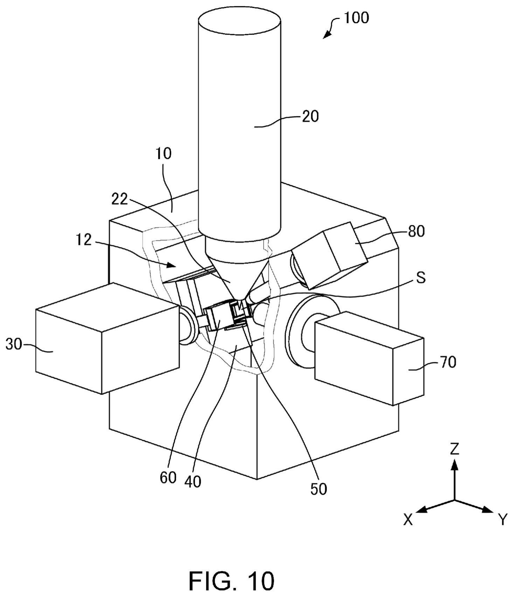

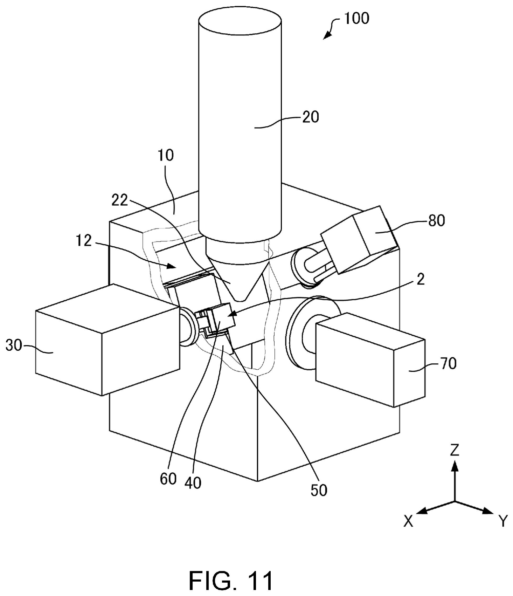

Next, a sample processing method using the sample processing apparatus 100 and a measurement method for measuring a sample processed by the sample processing method will be described. FIG. 9 is a flowchart illustrating an example of the measurement method including the sample processing method using the sample processing apparatus 100. FIGS. 10 and 11 are diagrams illustrating each step of the measurement method including the sample processing method using the sample processing apparatus 100.

Initially, as illustrated in FIG. 1, the sample holder 50 holding the sample S is mounted on the sample stage 40 (step S100).

First, the sample chamber 12 is vented, and the sample holder 50 holding the sample S is loaded into the sample chamber 12 through the door 14. Next, the sample holder 50 is mounted on the sample stage 40. After the sample holder 50 is mounted on the sample stage 40, the door 14 is closed, and the sample chamber 12 is evacuated. As a result, the sample chamber 12 is brought into a vacuum state. At this time, the sample holder 50 is located at the observation position.

Next, as illustrated in FIG. 10, a processing region is determined using an SEM image (step S102).

First, the sample holder 50 is tilted by 70° using the sample stage 40. As a result, an electron beam is allowed to be incident on the surface of the sample S at an angle of 70°. Next, the EBSD detector 70 is inserted and disposed in the vicinity of the sample S. This results in a state in which EBSD measurement becomes possible. Next, the sample S is irradiated with an electron beam from the SEM column 20 to acquire an SEM image of the sample S, and a processing region of the sample S is determined on the basis of the SEM image.

Next, as illustrated in FIG. 11, the sample S is accommodated in the container 2 (step S104).

First, using the sample stage 40, the sample holder 50 is moved from the observation position to the processing position. Specifically, the sample holder 50 located at the observation position is moved by a predetermined distance in the +X direction using the sample stage 40. As a result, the sample holder 50 is movable from the observation position to the processing position. Here, the shield 60 is fixed at the processing position. Therefore, when the sample holder 50 is moved to the processing position, the container 2 that accommodates the sample S is formed by the sample holder 50 and the shield 60.

Next, the sample S is subjected to laser processing (step S106).

First, using an optical microscope (not illustrated) attached to the housing 10, the processing region of the sample S within the container 2 is confirmed through the window portion 64. Next, the laser device 30 is caused to emit laser light. The laser light passes through the window portion 64 and is irradiated onto the sample S within the container 2. As a result, the processing region of the sample S is subjected to laser processing, thereby enabling the formation of the cross section of the sample S. Through the above steps, it is possible to form the cross section of the processing region of the sample S.

Next, as illustrated in FIG. 10, the processing region of the sample S that has been subjected to the laser processing is measured (step S108).

First, using the sample stage 40, the sample holder 50 is moved from the processing position to the observation position. Specifically, the sample holder 50 located at the processing position is moved by a predetermined distance in the -X direction using the sample stage 40. As a result, the sample holder 50 is movable from the processing position to the observation position. The shield 60 is fixed at the processing position. Therefore, when the sample holder 50 is moved from the processing position to the observation position, the sample S is exposed.

Next, the sample S is irradiated with an electron beam to acquire an SEM image of the sample S, and a determination is made using the SEM image as to whether the processing region that has been subjected to the laser processing has been irradiated with the electron beam. Next, the processing region of the sample S is irradiated with an electron beam to perform EBSD measurement and EDS measurement.

Here, depending on the processing conditions of the laser processing, the cross section of the processing region that has been subjected to the laser processing may be tilted. In this case, at the observation position, the cross section of the processing region of the sample S may not be oriented toward the EBSD detector 70. In such a case, as illustrated in FIG. 4, the sample S is tilted using the tilting mechanism 54 of the sample holder 50 so that the cross section of the processing region of the sample S is oriented toward the EBSD detector 70. As a result, the cross section of the processing region of the sample S is oriented toward the EBSD detector 70, thereby enabling accurate EBSD measurement.

Through the above steps, it is possible to measure the processing region of the sample S that has been subjected to laser processing.

Note that by repeatedly processing the sample S through steps S102, S104, and S106 and measuring the sample S through step S108 to acquire a plurality of cross-sectional images, and by reconstructing the acquired images, three-dimensional information on the sample S becomes obtainable. As described above, in the sample processing apparatus 100, the three-dimensional measurement of the sample S may be facilitated.

### 4. Effects

The sample processing apparatus 100 includes: the laser device 30 serving as a processing beam source that irradiates the sample S with a processing beam; the sample holder 50 that holds the sample S; the sample stage 40 on which the sample holder 50 is mounted; and the shield 60 disposed in the sample chamber 12. Furthermore, in the sample processing apparatus 100, the sample holder 50 and the shield 60 form the container 2 that accommodates the sample S, and the container 2 is provided with the window portion 64 that guides laser light as the processing beam into the container 2.

Therefore, in the sample processing apparatus 100, the sample S may be subjected to laser processing while being accommodated in the container 2, thereby enabling a reduction in the scattering of cutting debris within the sample chamber 12. Accordingly, it is possible to reduce the likelihood of cutting debris adhering to the SEM column 20, the EBSD detector 70, the EDS detector 80, and the like, which form the sample processing apparatus 100. In addition, it is also possible to reduce the likelihood of cutting debris adhering to the inner surfaces of the sample chamber 12. As a result, in the sample processing apparatus 100, the sample S may be subjected to laser processing without degrading the performance of the apparatus.

In addition, in the sample processing apparatus 100, both the processing of the sample S and the observation and analysis of the sample S may be performed without removing the sample holder 50 from the sample stage 40. Therefore, in the sample processing apparatus 100, the throughput of analysis and observation may be improved, and measurements may be performed with high positional accuracy. Accordingly, in the sample processing apparatus 100, three-dimensional measurement may be facilitated in which the processing of the sample S and the observation and analysis of the sample S are repeatedly performed to acquire three-dimensional information on the sample S.

The sample processing apparatus 100 includes the SEM column 20 that is an observation beam source that irradiates the sample S with an electron beam serving as an observation beam. Furthermore, in the sample processing apparatus 100, the sample stage 40 moves the sample holder 50 between the observation position at which the sample S is irradiated with an electron beam and the processing position at which the sample S is irradiated with laser light. By moving the sample holder 50 to the processing position, the sample S becomes accommodated in the container 2. As described above, in the sample processing apparatus 100, the sample holder 50 is moved from the observation position to the processing position using the sample stage 40, thereby accommodating the sample S in the container 2. Therefore, in the sample processing apparatus 100, a reduction in cutting debris that scatters within the sample chamber 12 may be facilitated.

In the sample processing apparatus 100, the shield 60 is fixed at the processing position. Therefore, in the sample processing apparatus 100, it is possible to accommodate the sample S in the container 2 by moving the sample holder 50 to the processing position.

In the sample processing apparatus 100, the sample holder 50 is provided with the protruding portion 59, and the shield 60 is provided with the recess portion 66 into which the protruding portion 59 is inserted. Therefore, in the sample processing apparatus 100, it is possible to reduce the likelihood of cutting debris escaping from the connecting portion between the sample holder 50 and the shield 60 to the outside of the container 2.

In the sample processing apparatus 100, the sample holder 50 has the sample platform 58 on which the sample S is placed, and the protruding portion 59 surrounds the sample platform 58. Therefore, in the sample processing apparatus 100, it is possible to reduce the likelihood of cutting debris escaping from the connecting portion between the sample holder 50 and the shield 60 to the outside of the container 2.

In the sample processing apparatus 100, the sample holder 50 has the tilting mechanism 54 that tilts the sample S. Therefore, in the sample processing apparatus 100, it is possible to orient the cross section of the processing region of the sample S toward the EBSD detector 70.

In the sample processing apparatus 100, the processing beam is laser light, and the material of the window portion 64 allows the laser light to pass through. Therefore, in the sample processing apparatus 100, the sample S may be subjected to laser processing within the container 2.

In the sample processing apparatus 100, the window portion 64 is replaceable. Therefore, in the sample processing apparatus 100, the window portion 64 may be replaced when cutting debris adheres to the window portion 64. Furthermore, for example, the window portion 64 may be cleaned when cutting debris adheres to the window portion 64.

The sample processing method using the sample processing apparatus 100 includes: mounting the sample holder 50 holding the sample S on the sample stage 40 disposed in the sample chamber 12; observing the sample S using an observation beam and determining a processing region of the sample S; accommodating the sample S in the container 2 formed by the shield 60 and the sample holder 50; and guiding a processing beam into the container 2 through the window portion 64 provided in the container 2 and processing the sample S accommodated in the container 2 using the processing beam.

Therefore, in the sample processing method using the sample processing apparatus 100, the sample S may be processed within the container 2, thereby enabling a reduction in cutting debris that scatters within the sample chamber 12.

### 5. Modified Examples

### 5.1. First Modified Example

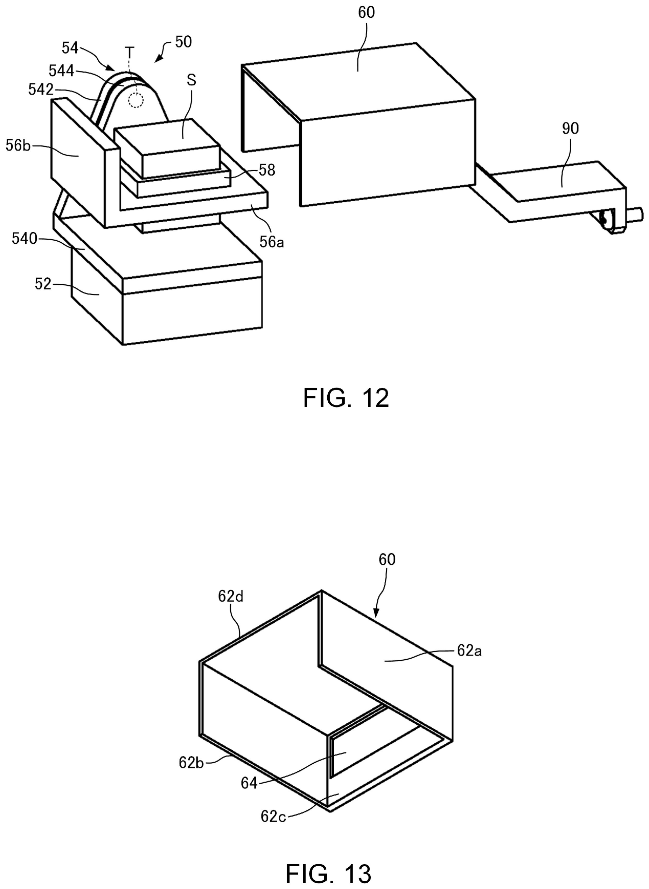

FIG. 12 is a perspective view schematically illustrating a modified example of the sample holder 50 and the shield 60. FIG. 13 is a perspective view schematically illustrating a modified example of the shield 60.

As illustrated in FIGS. 12 and 13, the sample holder 50 may not be provided with a protruding portion, and the shield 60 may not be provided with a recess portion. Even in such a case, the sample S is accommodated in the container 2, thereby enabling a reduction in cutting debris that scatters within the sample chamber 12. Furthermore, compared to a case in which the sample holder 50 is provided with the protruding portion 59 and the shield 60 is provided with the recess portion 66, the configurations of the sample holder 50 and the shield 60 may be more simplified.

### 5.2. Second Modified Example

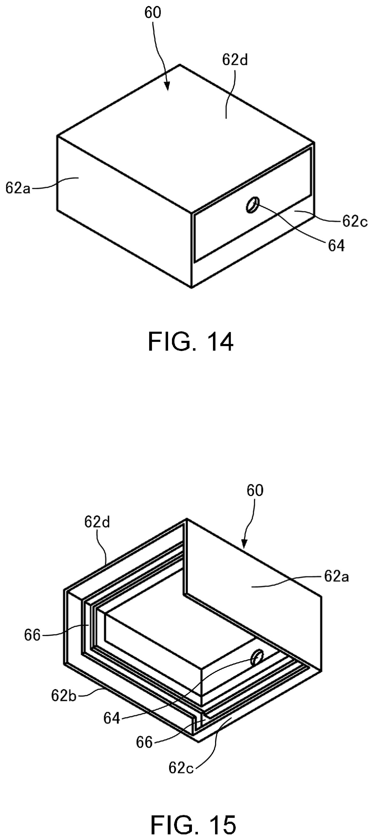

FIGS. 14 and 15 are perspective views schematically illustrating a modified example of the shield 60. In the example illustrated in FIGS. 6 and 7 described above, the window portion 64 is made of glass that allows laser light to pass through. However, as illustrated in FIGS. 14 and 15, the window portion 64 may be a through-hole that penetrates the container 2.

In the example illustrated in FIGS. 14 and 15, the window portion 64 is a through-hole that penetrates the fifth member 62c of the shield 60. When the sample S is subjected to laser processing, laser light emitted from the laser device 30 passes through a through-hole serving as the window portion 64 and is irradiated onto the sample S accommodated in the container 2. For example, the diameter of the through-hole is greater than that of the laser light.

When the window portion 64 is a through-hole, the processing beam may be laser light, an ion beam, a focused ion beam (FIB), a plasma focused ion beam, an electron beam, or the like.

Even when the window portion 64 is a through-hole, the sample S is accommodated in the container 2 as in a case in which the window portion 64 is made of glass, thereby enabling a reduction in cutting debris that scatters within the sample chamber 12.

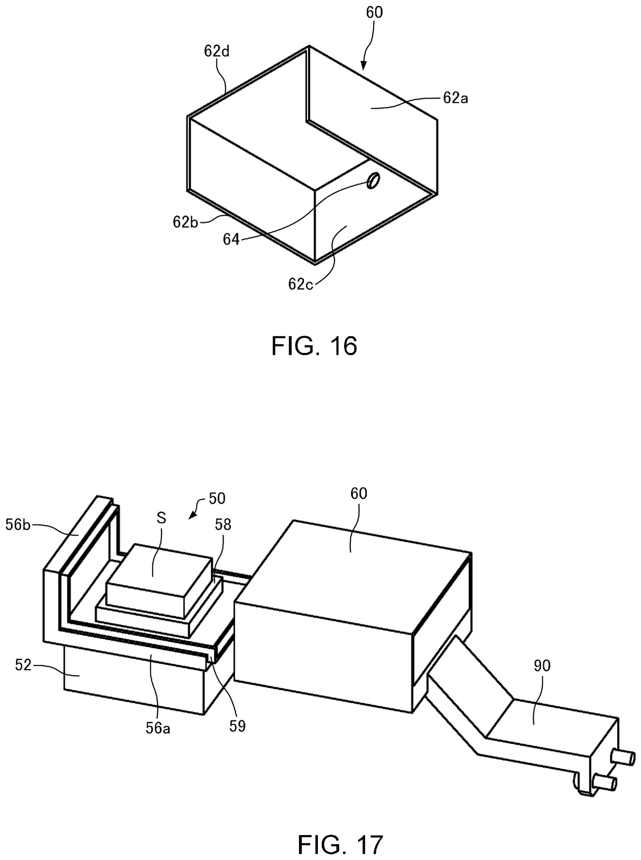

FIG. 16 is a perspective view schematically illustrating a modified example of the shield 60. As illustrated in FIG. 16, when the window portion 64 is a through-hole, the shield 60 may not be provided with the recess portion 66, and the sample holder 50 may not be provided with the protruding portion 59 as in the example illustrated in FIGS. 12 and 13. Even in the example illustrated in FIG. 16, the sample S is accommodated in the container 2, thereby enabling a reduction in cutting debris that scatters within the sample chamber 12.

### 5.3. Third Modified Example

FIG. 17 is a perspective view schematically illustrating a modified example of the sample holder 50 and the shield 60. As illustrated in FIG. 17, the sample holder 50 may not have the tilting mechanism 54 that tilts the sample S. In this case, for example, the sample S may be tilted using the tilting mechanism of the sample stage 40.

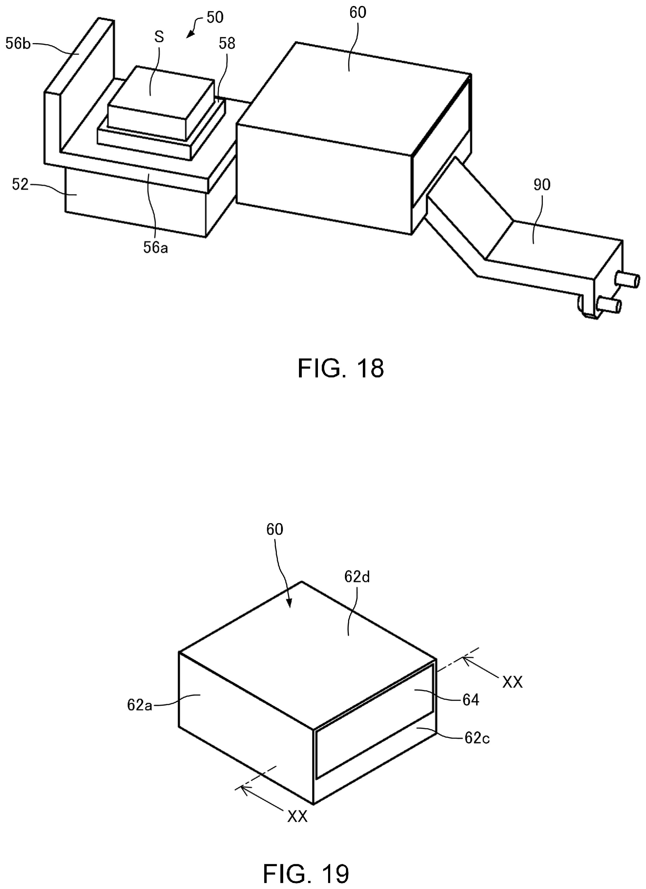

FIG. 18 is a perspective view schematically illustrating a modified example of the sample holder 50 and the shield 60. As illustrated in FIG. 18, the sample holder 50 may not have the tilting mechanism 54 that tilts the sample S. In the example illustrated in FIG. 18, the sample holder 50 is not provided with a protruding portion, and the shield 60 is not provided with a recess portion.

### 5.4. Fourth Modified Example

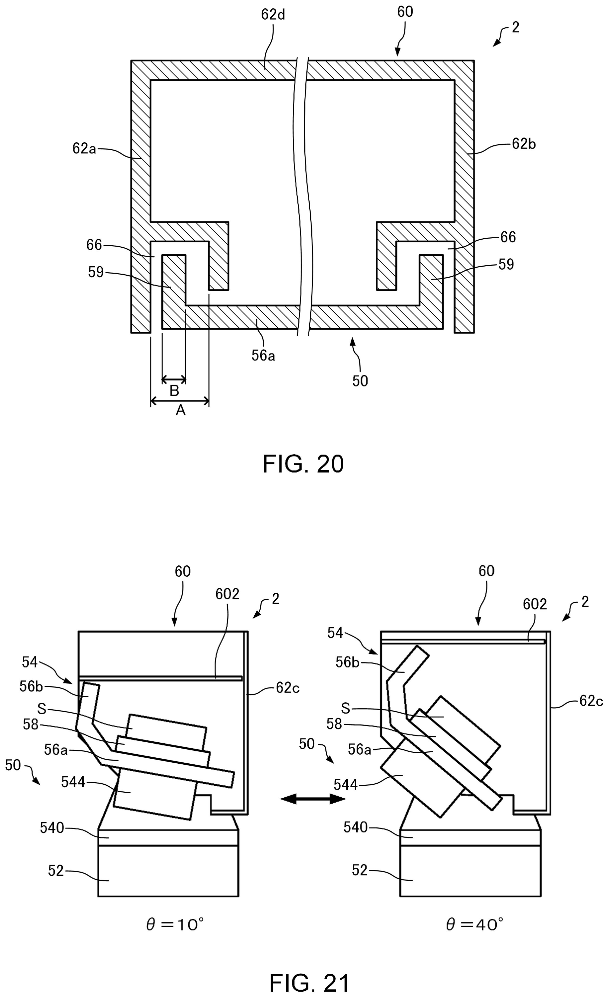

FIG. 19 is a perspective view schematically illustrating a modified example of the container 2. FIG. 20 is a cross-sectional view schematically illustrating the connecting portion between the sample holder 50 and the shield 60. Note that FIG. 20 is a cross-sectional view taken along line XX-XX in FIG. 19.

As illustrated in FIG. 20, the protruding portion 59 of the sample holder 50 and the recess portion 66 of the shield 60 may not be in contact with each other. Because the protruding portion 59 is inserted into the recess portion 66, the path connecting the inside and outside of the container 2 may be bent even if the protruding portion 59 and the recess portion 66 are not in contact with each other. Accordingly, it is possible to reduce the likelihood of cutting debris escaping from the connecting portion between the sample holder 50 and the shield 60 to the outside of the container 2.

Because the protruding portion 59 and the recess portion 66 are not in contact with each other in the sample holder 50 and the shield 60, the sample holder 50 does not come into contact with the shield 60 when moving from the observation position to the processing position. As a result, it is possible to reduce the displacement of the sample holder 50. For example, when the sample holder 50 comes into contact with the shield 60, the sample holder 50 may be displaced due to an impact generated by the contact between the sample holder 50 and the shield 60. By preventing the contact between the sample holder 50 and the shield 60, it is possible to reduce the displacement of the sample.

In the example illustrated in FIG. 20, a width A of the recess portion 66 is greater than a width B of the protruding portion 59. A gap is formed between the recess portion 66 and the protruding portion 59. Therefore, when the sample holder 50 is moved to the processing position to insert the protruding portion 59 into the recess portion 66, the displacement of the sample holder 50 corresponding to the size of the gap is allowed.

Note that, although not illustrated, a shock absorbing member may be disposed in the recess portion 66 to absorb a shock generated by the contact between the protruding portion 59 and the recess portion 66. For example, as the shock absorbing member, an elastic member that elastically deforms during the collision of the protruding portion 59 may be disposed in the recess portion 66. As a result, it is possible to reduce the displacement of the sample holder 50. As such an elastic member, rubber, a spring, a resin, or the like may be used.

### 5.5. Fifth Modified Example

FIG. 21 illustrates a modified example of the container 2. FIG. 21 illustrates a case in which the tilt angle θ of the sample platform 58 is 10° and a case in which the tilt angle θ of the sample platform 58 is 40°. As illustrated in FIG. 21, the height of the container 2 may be variable.

The shield 60 has a lid portion 602 that forms an upper portion of the container 2. The lid portion 602 is disposed inside members forming three side surfaces of the container 2, that is, the third member 62a, the fourth member 62b, and the fifth member 62c illustrated in FIG. 7.

The lid portion 602 is configured to be movable. The lid portion 602 is supported by the sample holder 50. In the illustrated example, the lid portion 602 is supported by the second member 56b that forms the container 2. Therefore, when the sample platform 58 is tilted using the tilting mechanism 54, the lid portion 602 moves in the vertical direction. Note that, although not illustrated, the lid portion 602 may be supported by the sample platform 58 or by another member tilted by the tilting mechanism 54.

In the example illustrated in FIG. 21, the height of the lid portion 602 at a tilt angle θ of 40° is greater than the height of the lid portion 602 at a tilt angle θ of 10°. The greater the tilt angle θ of the sample platform 58, the greater the height of the lid portion 602. In this way, the height of the container 2 changes as the height of the lid portion 602 changes.

By changing the height of the container 2 in accordance with the tilt angle θ, it is possible to tilt the sample S during laser processing. Accordingly, in the example illustrated in FIG. 21, the sample S may be subjected to laser processing while being tilted at various angles.

If the height of the lid portion 602 is fixed at a height corresponding to the maximum tilt angle of the sample platform 58, the gap between the sample holder 50 and the lid portion 602 increases when the tilt angle θ is reduced. On the other hand, by changing the height of the container 2 in accordance with the tilt angle θ, it is possible to maintain a constant gap between the sample holder 50 and the lid portion 602 even if the tilt angle θ changes.

Note that the shield 60 may have a driving unit that moves the lid portion 602. For example, the driving unit may move the lid portion 602 using power from a motor or the like. The driving unit moves the lid portion 602 in conjunction with, for example, the tilting of the sample platform 58. As a result, it is possible to change the height of the container 2 in accordance with the tilt angle θ.

### 5.6. Sixth Modified Example

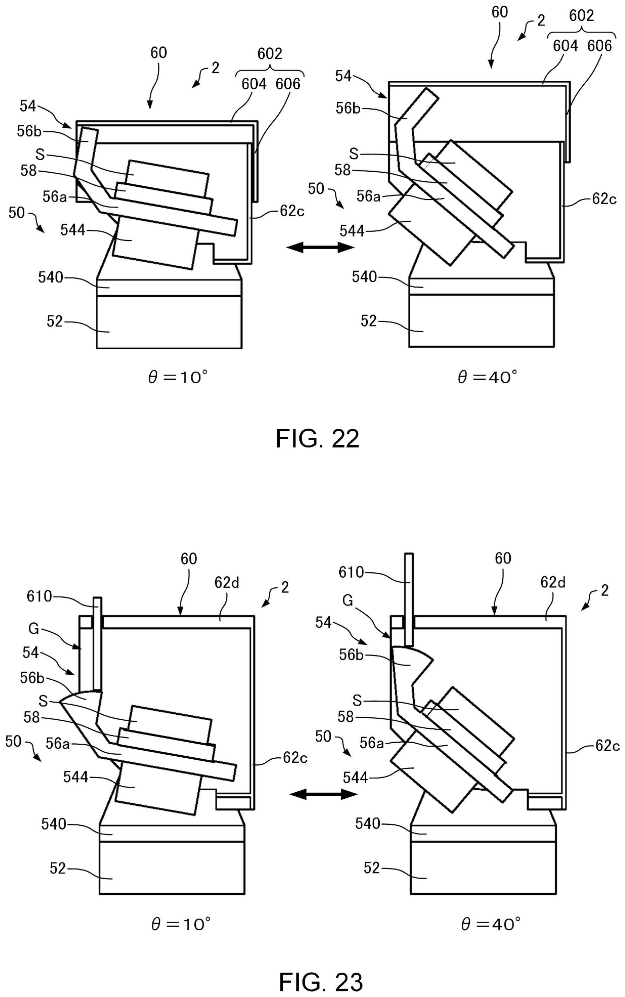

FIG. 22 is illustrates a modified example of the container 2. In the example illustrated in FIG. 22, the lid portion 602 is movable, and the height of the container 2 is variable, as in the example illustrated in FIG. 21.

As illustrated in FIG. 22, the lid portion 602 has an upper surface portion 604 that forms an upper portion of the container 2 and a side surface portion 606 that overlaps the members (i.e., the third member 62a, the fourth member 62b, and the fifth member 62c illustrated in FIG. 7) forming the three side surfaces of the container 2. The side surface portion 606 is in contact with the outer surface of the fifth member 62c. Although not illustrated, the side surface portion 606 is also in contact with the outer surface of the third member 62a and the outer surface of the fourth member 62b.

Similarly to the example illustrated in FIG. 21, the lid portion 602 is supported by the sample holder 50. When the sample platform 58 is tilted using the tilting mechanism 54, the lid portion 602 moves in the vertical direction.

In the example illustrated in FIG. 22, the height of the container 2 is variable as in the example illustrated in FIG. 21 described above. Therefore, the same effects as in the example illustrated in FIG. 21 described above may be obtained.

### 5.7. Seventh Modified Example

FIG. 23 illustrates a modified example of the container 2. In the example illustrated in FIG. 23, the sample holder 50 has a moving wall 610 that moves in accordance with the tilting of the sample platform 58.

The moving wall 610 forms the container 2 together with the first member 56a and the second member 56b. The moving wall 610 seals a gap G between the second member 56b that defines a side surface of the container 2 and the sixth member 62d that defines the upper surface of the container 2.

The moving wall 610 is configured to be movable. The moving wall 610 is supported by the second member 56b. Therefore, when the sample platform 58 is tilted using the tilting mechanism 54, the moving wall 610 moves in the vertical direction. Note that, although not illustrated, the moving wall 610 may be supported by the sample platform 58 or by another member tilted by the tilting mechanism 54.

Because the position of the second member 56b changes in accordance with the tilt angle θ, the size of the gap G between the second member 56b and the sixth member 62d also changes in accordance with the tilt angle θ. In the example illustrated in FIG. 23, the size of the gap G at a tilt angle θ of 10° is greater than the size of the gap G at a tilt angle θ of 40°.

As illustrated in FIG. 23, the moving wall 610 moves in accordance with the tilt angle θ and seals the gap G between the second member 56b and the sixth member 62d. Therefore, it is possible to tilt the sample S during laser processing.

Note that the sample holder 50 may have a driving unit that moves the moving wall 610. For example, the driving unit may move the moving wall 610 using power from a motor or the like. The driving unit may move the moving wall 610 in conjunction with, for example, the tilting of the sample platform 58.

### 5.8. Eighth Modified Example

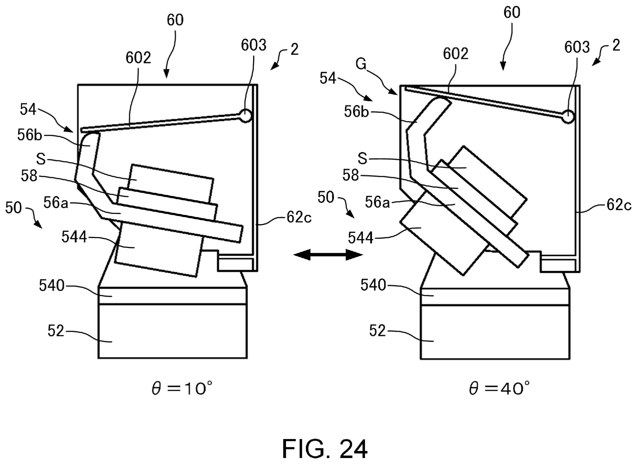

FIG. 24 illustrates a modified example of the container 2. In the example illustrated in FIG. 24, the lid portion 602 is movable, and the height of the container 2 is variable, as in the example illustrated in FIG. 21.

The lid portion 602 is connected to a shaft member 603. The shaft member 603 is fixed to the fifth member 62c. The shaft member 603 serves as the rotating shaft of the lid portion 602. Therefore, the lid portion 602 is rotatable about the shaft member 603 serving as a rotating shaft.

One end of the lid portion 602 is connected to the shaft member 603, and the other end thereof is supported by the sample holder 50. In the example illustrated in FIG. 24, the other end of the lid portion 602 is supported by the second member 56b of the sample holder 50. Therefore, when the sample platform 58 is tilted using the tilting mechanism 54, the lid portion 602 rotates about the shaft member 603 serving as a rotating shaft and moves in the vertical direction.

In the example illustrated in FIG. 24, the height of the container 2 is variable as in the example illustrated in FIG. 21 described above. Therefore, the same effects as in the example illustrated in FIG. 21 described above may be obtained. Note that the shield 60 may have a driving unit that moves the lid portion 602.

### 5.9. Ninth Modified Example

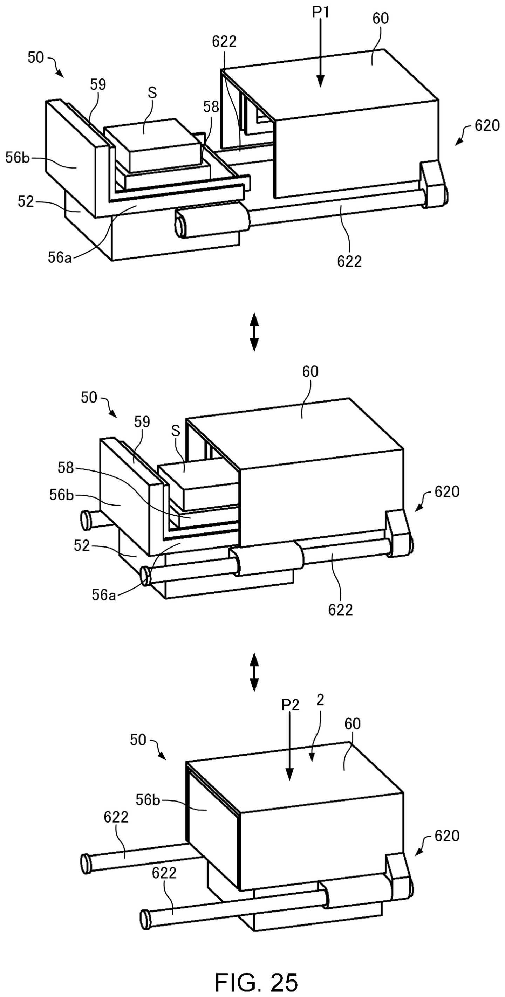

FIG. 25 is a set of perspective views schematically illustrating a modified example of the sample holder 50 and the shield 60. FIG. 25 illustrates a state in which the shield 60 is located at a first position P1, a state in which the shield 60 is being moved between the first position P1 and a second position P2, and a state in which the shield 60 is located at the second position P2.

The sample processing apparatus 100 has a moving mechanism 620 that moves the shield 60. The moving mechanism 620 includes two rails 622. Although not illustrated, the moving mechanism 620 includes a driving unit that moves the shield 60 using power from a motor or the like.

The two rails 622 movably support the shield 60. The shield 60 slides in the horizontal direction on the two rails 622. The shield 60 moves between the first position P1 and the second position P2.

The first position P1 is a position at which the shield 60 does not overlap the sample holder 50. In a state in which the shield 60 is located at the first position P1, the sample S is not accommodated in the container 2 and is exposed. Therefore, irradiating the sample S with an electron beam enables SEM observation, EBSD measurement, and EDS measurement.

The second position P2 is a position at which the shield 60 overlaps the sample holder 50. In a state in which the shield 60 is located at the second position P2, the sample holder 50 and the shield 60 form the container 2. That is, the sample S is accommodated in the container 2. Accordingly, in a state in which the shield 60 is located at the second position P2, the sample S may be subjected to laser processing.

In the example illustrated in FIG. 25, by moving the shield 60, it is possible to switch between a state in which the sample S is accommodated in the container 2 and a state in which the sample S is exposed. Accordingly, for example, the observation position may be aligned with the processing position. That is, the observation and analysis of the sample S and the laser processing of the sample S may be performed at the same position without moving the sample holder 50 on the sample stage 40.

### 5.10. Tenth Modified Example

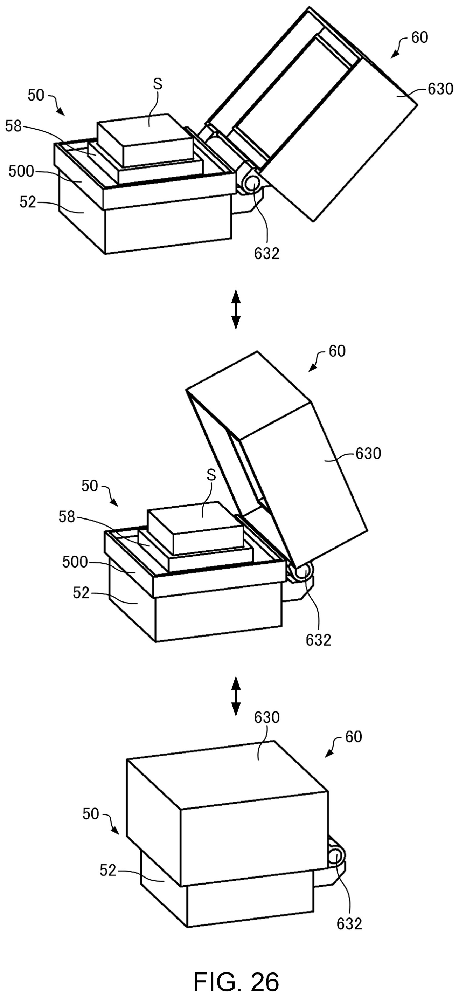

FIG. 26 is a set of perspective views schematically illustrating a modified example of the sample holder 50 and the shield 60. FIG. 26 illustrates a state in which the shield 60 is opened and the sample S is exposed, a state in which the shield 60 is being opened or closed, and a state in which the shield 60 is closed and the sample S is accommodated in the container 2.

The shield 60 includes a lid portion 630 and a hinge portion 632 that openably and closably supports the lid portion 630. Although not illustrated, the shield 60 further includes a driving unit that opens and closes the lid portion 630 using power from a motor or the like. The lid portion 630 is connected to the sample holder 50 via the hinge portion 632. The lid portion 630 defines the four side surfaces and the upper surface of the container 2. The lid portion 630 is provided with a window portion that allows laser light to pass through.

The sample holder 50 includes a bottom portion 500 that defines the bottom surface of the container 2. When the lid portion 630 is closed, the container 2 that accommodates the sample S is formed by the lid portion 630 and the bottom portion 500.

In the example illustrated in FIG. 26, for example, by opening and closing the lid portion 630, it is possible to switch between a state in which the sample S is accommodated in the container 2 and a state in which the sample S is exposed. Accordingly, for example, the observation position may be aligned with the processing position. That is, the observation and analysis of the sample S and the laser processing of the sample S may be performed at the same position without moving the sample holder 50 on the sample stage 40.

### 5.11. Eleventh Modified Example

The container 2 illustrated in FIG. 5 described above surrounds the four sides of the sample S with six surfaces. However, the container 2 may not necessarily surround the four sides of the sample S. For example, the container 2 may surround the sample S with five surfaces, with one surface open. Furthermore, the container 2 may have, for example, a dome shape, which is a semi-spherical shape or a protruding structure similar to a semi-spherical shape.

### 5.12. Twelfth Modified Example

In the embodiments described above, the observation beam is an electron beam, and the processing beam is laser light. However, the observation beam is not limited to an electron beam. For example, a focused ion beam, a plasma focused ion beam, or the like may be used as the observation beam. Furthermore, for example, a focused ion beam, a plasma focused ion beam, a broad ion beam having a diameter of approximately several millimeters, or the like may be used as the processing beam. Furthermore, for example, a focused ion beam may be used as the observation beam and the processing beam. That is, the observation beam and the processing beam may be the same.

Note that the above embodiments and the modified examples are examples and the invention is not limited thereto. For example, the embodiments and modified examples may be combined as appropriate.

The invention is not limited to the above-described embodiments, and various modifications can be made. For example, the invention includes configurations that are substantially the same as the configurations described in the embodiments. Substantially same configurations mean configurations having the same functions and methods, for example. The invention also includes configurations obtained by replacing non-essential elements of the configurations described in the embodiments with other elements. The invention further includes configurations obtained by adding known art to the configurations described in the embodiments.

## Claims

1. A sample processing apparatus that irradiates a sample disposed in a sample chamber with a processing beam to process the sample, the sample processing apparatus comprising:
a processing beam source that irradiates the sample with the processing beam;
a sample holder that holds the sample;
a sample stage on which the sample holder is mounted; and
a shield disposed in the sample chamber, wherein
the sample holder and the shield form a container that accommodates the sample, and
the container is provided with a window portion that guides the processing beam into the container.

2. The sample processing apparatus according to claim 1, further comprising:
an observation beam source that irradiates the sample with an observation beam, wherein
the sample stage moves the sample holder between an observation position at which the sample is irradiated with the observation beam and a processing position at which the sample is irradiated with the processing beam, and
the sample is accommodated in the container by moving the sample holder to the processing position.

3. The sample processing apparatus according to claim 2, wherein
the shield is fixed at the processing position.

4. The sample processing apparatus according to claim 1 or 2, wherein
the sample holder is provided with a protruding portion, and
the shield is provided with a recess portion into which the protruding portion is inserted.

5. The sample processing apparatus according to claim 4, wherein
the sample holder has a sample platform on which the sample is placed, and
the protruding portion surrounds the sample platform.

6. The sample processing apparatus according to claim 4 or 5, wherein
when the sample holder and the shield form the container, the protruding portion and the recess portion are not in contact with each other.

7. The sample processing apparatus according to claim 1 or 2, wherein
the shield is provided with a protruding portion, and
the sample holder is provided with a recess portion into which the protruding portion is inserted.

8. The sample processing apparatus according to any one of claims 1 to 7, wherein
the sample holder has a tilting mechanism that tilts the sample.

9. The sample processing apparatus according to claim 8, wherein
a height of the container is variable.

10. The sample processing apparatus according to claim 9, wherein
the shield has a lid portion that forms an upper portion of the container, and
the lid portion is movable.

11. The sample processing apparatus according to any one of claims 1 to 10, wherein
the processing beam is laser light, and
the window portion allows the laser light to pass through.

12. The sample processing apparatus according to claim 11, wherein
the window portion is replaceable.

13. The sample processing apparatus according to any one of claims 1 to 10, wherein
the window portion is a through-hole that penetrates the container.

14. A sample processing method comprising:
mounting a sample holder holding a sample on a sample stage disposed in a sample chamber of a sample processing apparatus;
observing the sample using an observation beam and determining a processing region of the sample;
accommodating the sample in a container formed by a shield and the sample holder; and
guiding a processing beam into the container through a window portion provided in the container and processing the sample accommodated in the container using the processing beam.
